# EUROPEAN PATENT SPECIFICATION

(11) **EP 2 984 678 B1**
(45) Date of publication and mention of the grant of the patent: **06.09.2017**
(21) Application number: 14838188.2
(22) Date of filing: 21.07.2014
(51) Int. Cl.: H01L 21/205, C23C 16/455, C23C 16/30, C30B 25/08, C30B 29/40, C30B 29/48, H01L 21/02, C23C 16/458, C30B 25/02

(54) **METHOD OF PRODUCING EPITAXIAL LAYER OF BINARY SEMICONDUCTOR MATERIAL**
VERFAHREN ZUR ERZEUGUNG EINER EPITAKTISCHEN SCHICHT AUS EINEM BINÄREN HALBLEITERMATERIAL
PROCÉDÉ DE PRODUCTION D'UNE COUCHE ÉPITAXIALE DE MATÉRIAU SEMI-CONDUCTEUR BINAIRE

(30) Priority: 19.08.2013 RU 2013138480
(43) Date of publication of application: 17.02.2016
(73) Proprietor: Arendarenko, Alexey Andreevich, g. Zelenograd 124683 (RU); Burobin, Valery Anatol`evich, Moscow 115446 (RU); Zverev, Andrey Vladimirovich, Moscow 119192 (RU)
(72) Inventor: Arendarenko, Alexey Andreevich, g. Zelenograd 124683 (RU); Burobin, Valery Anatol`evich, Moscow 115446 (RU); Zverev, Andrey Vladimirovich, Moscow 119192 (RU)
(74) Representative: Anohins, Vladimirs
(86) International application number: PCT/RU2014/000538
(87) International publication number: WO 2015/026265

(56) References cited:
- WO-A1-2013/075390
- JP-A- 2004 014 953
- RU-C1- 2 187 172
- RU-C2- 2 414 549
- US-A- 4 976 996
- US-A1- 2004 173 150
- US-A1- 2010 263 588
- US-A1- 2012 240 853

## Description

### Field of Invention

The invention relates to the field of microelectronics and may be used for producing epitaxial structures of III-V compound semiconductor materials and II-VI compound semiconductor materials by means of chemical vapour deposition of metal-organic compounds and hydrides.

### Background of Invention

Method of producing III-V epitaxial structures (later known as MOCVD) was proposed by Manasevit (see Manasevit H.M. Single-Crystal Gallium Arsenide on Insulating Substrates Appl. Phys. Let.12, 156 (1968)). The method consisted in that a metal-organic compound (MOC) of a group III element, namely trimethylgallium, and hydride of a group V element (arsine) were transferred by hydrogen flow into a reactor containing a hot surface on which a monocrystalline substrate was disposed, and a gallium arsenide epitaxial layer was grown on the hot substrate.

Later it has been discovered that reactions between MOC and hydride occur not only on the hot surface, but also in the gaseous phase (homogeneous reactions). In order to suppress such reactions devices in which MOC and hydride are supplied separately to the growth region have been used (see e.g. US patent application 2009/0229754 in which a device having a reaction gas introduction system of "shower sprinkler" type is used). However, these components are mixed in the growth region and, as a result, it is impossible to avoid reactions between them in the gaseous phase completely. Products of homogeneous reactions being deposited on the growth surface impair quality of the epitaxial layers. This problem became a matter of particular concern in view of development of technology for producing heteroepitaxial structures (HES) having quantum-dimensional wells (particularly GaAlN-based HES for LEDs).

There are some known solutions (see e.g. US patent application 2010/0263588) in which MOC and hydrides are supplied alternately into a reactor in order to avoid homogeneous reactions. This can be implemented e.g. by providing movement of a gas-vapor mixture (GVM) in such a way that group III components are supplied first, then the reactor is blown off, next group V components are supplied, then the reactor is blown off again and so on until a layer of necessary thickness has been grown. However in this case the process duration is increased due to that components are supplied sequentially into the reactor, and unsteady flow of GVM occurs i.e. transient processes take place in the gaseous phase, which processes depend on the GVM flows switch, so in turn this causes loss in HES quality. These methods are usually used for producing HES in laboratory (research) practice. It is as well known to introduce reactive gases radially through a perforated ring (see e.g. US 2012/0240853).

Using separation walls in a reactor having a rotary substrate holder for dividing thereof into segments with separate supply of reaction components into these segments (see e.g. US patent 8043432) causes undesirable deposition of the reaction products on the segments and creates a risk of these products crumbling and falling onto the epitaxial layer during its growth.

Thus, no solution is known so far, which eliminates homogeneous reactions and assures large-scale HES production (e.g. more than 40 substrates at once).

### Summary of Invention

Terms, expressions and abbreviations used herein have the following meanings.

MOCVD (Metalorganic chemical vapour deposition) means a method of chemical deposition from gaseous phase containing vapour of metal-organic compounds.

HES means heteroepitaxial structures.

MOC means a metal-organic compound.

GVM means a gas-vapour mixture which is a reaction gas, particularly vapour of a metal-organic compound in a carrier gas and/or a mixture of hydride of a group V element of the periodic table and a carrier gas.

Separation segment means an imaginary part (region) of a reaction chamber in which flow of a carrier gas moving along radius of the reaction chamber separates flows of reaction gases in adjacent segments of the reaction chamber, particularly the MOC segment and the hydride segment.

TMA means trimethylaluminium.

TMG means trimethylgallium.

TMI means trimethylindium.

Carrier gas means a gas used as a carrier, which does not contain any compounds which may deposit on the substrate. Hydrogen, nitrogen or a mixture thereof is usually used as a carrier gas.

Other terms and expressions are used in their ordinary meanings being well-known to those skilled in the art.

This invention is aimed at providing a method of MOCVD that enables growing epitaxial layers of semiconductor materials both in usual way and via atomic layer deposition with continuous reaction gases flow (which allows increasing the method capacity in comparison to methods using intermittent supply of reaction gases).

In the method of producing epitaxial layer of a binary semiconductor material on a monocrystalline substrate via metal-organic chemical vapour deposition (MOCVD), the solution to the above-stated problem uses the following means:
(A) a reactor having a reaction chamber being round relative to the vertical central axis;
(B) a substrate holder disposed horizontally in the reaction chamber and adapted to rotate relative to the vertical central axis;
(C) a round screen disposed in the reaction chamber at a distance of approximately 15 to 40 mm above the substrate holder, and the diameter of the screen is bigger than the diameter of the substrate holder;
   wherein
   (a) a predetermined temperature of the substrate holder is maintained;
   (b) the substrate holder is rotated uniformly relative to the vertical central axis;
   (c) at least two reaction gases are supplied simultaneously and separately into different radial segments of the reaction chamber; wherein at least one of the gases contains a metal-organic compound (MOC) able to decompose in order to provide formation of a layer of atoms of an element of group III or II, and at least another one of the gases contains hydride of an element of group V or VI correspondingly, the hydride able to react with the atoms of the element of group III or II in the layer, correspondingly;
   (d) the reaction gases are supplied in such an order that the layer produced from the reaction gas containing MOC of the element of group III or II is exposed to action of the reaction gas containing hydride of the element of group V or VI correspondingly;
   (e) in order to avoid mixing the reaction gases to each other, a carrier gas is supplied into radial segments between the flows of the reaction gases;
   (f) the reaction gases and the carrier gas are supplied into the reaction chamber continuously during the whole time of the layer growth;
   (g) the reaction gases and the carrier gas are supplied in such a way that movement thereof in radial direction with speed being uniform relative to the same diameter is provided in every segment within the reaction chamber;
   (h) the circular velocity of the substrate holder rotation, the concentration of MOC in the reaction gas, and the reaction gas consumption rate are provided in such a way that thickness of the layer deposited at one whole rotation cycle of the substrate holder is approximately 0.6 to 1.0 of monoatomic layer thickness;
   (i) the reaction gases and the carrier gas are supplied substantially horizontally via groups of openings having diameter less than 1 mm and disposed with surface density of 5 to 20 openings per square centimeter in such a way that the gases flow in radial direction above the substrate holder laminarly in a displacement manner and thickness d of the growing layer is substantially equal to *k*×*a*×*n*, wherein
      *k* is a positive real number characterizing the portion of the monoatomic layer thickness, deposited at one whole rotation cycle of the substrate holder;
      *a* is a positive real number characterizing the lattice parameter of the growing material;
      *n* is a positive integer number characterizing the number of whole rotation cycles of the substrate holder.

The above-described method provides improved HES quality.

The improvement is achieved by the following means:
(A) exclusion of penetration of reaction gas containing MOC of the element of group III (or II) into the segment of the reaction gas containing the compound of the element of group V (or VI) and vice versa;
(B) provision for laminar flow of the mixture of the reaction gases and the carrier gas;
(C) exclusion of gas flow swirl in order to avoid capturing particles by the flow and relocation thereof into the HES growth region;
(D) elimination of conditions under which recirculation cells might appear;
(E) provision for steady and monotonous change in the GVM components concentration across the HES growth region;
(F) use of separation flow of the carrier gas instead of separation walls between segments so as to avoid the risk of ingress of deposited reaction products from the separation walls onto the growing epitaxial layer, and to avoid deceleration and turbulization of the gas flows in the vicinity of the walls.

A person skilled in the art knows that growing a layer having required composition is assured by that the substrates are disposed on the rotary substrate holder in the reactor being symmetrical relative to the vertical central axis, the substrates are heated, and the reaction gas containing the group III (or II) element MOC is supplied continuously, the gas flow containing the group V (or VI) compound is supplied continuously, the carrier gas is supplied continuously, the layer is grown, and gaseous reaction products are removed, wherein the supply of all gases, first of all the reaction gases containing the group III (or II) element MOC and the group V (or VI) compound is performed spatially separated and interlaced in such a way that the carrier gas flow separates the gas flows containing compounds of the group III (or II) elements and the group V (or VI) elements, the layer deposition is performed in a cycle manner and the layer part of monoatomic or near monoatomic thickness is grown at every cycle.

The reactor used for growing the layer is symmetrical relative to the vertical central axis and it comprises at least two segments into which the reaction gases are supplied continuously during the whole time of the epitaxial layer(s) growth, and formation of the growing layer is performed by sequential formation of an atomic layer of the group III (or II) elements and then an atomic layer of the group V (or VI) elements by virtue of alternate movement of the substrate(s) positioned on the rotary substrate holder from the region of reaction gas flow containing the group III (or II) elements MOC to the region of reaction gas flow containing the group V (or VI) element compound through the separation regions having the carrier gas flow.

In one embodiment of the method, the reaction gas containing at least two compounds of elements belonging to group III (or II) of the periodic table is supplied into the reactor segments and the reaction gas containing at least one hydride of an element belonging to group V (or VI) of the periodic table is correspondingly supplied into the other segment of the reactor.

In one of the most preferable embodiments, in order to reduce amount of depositions on the screen surface and avoid conditions causing formation of turbulence of the flows, the temperature of the screen is maintained in the range of 0.6 to 0.9 in relation to the temperature of the substrate holder so as to avoid formation of recirculation in the reaction chamber.

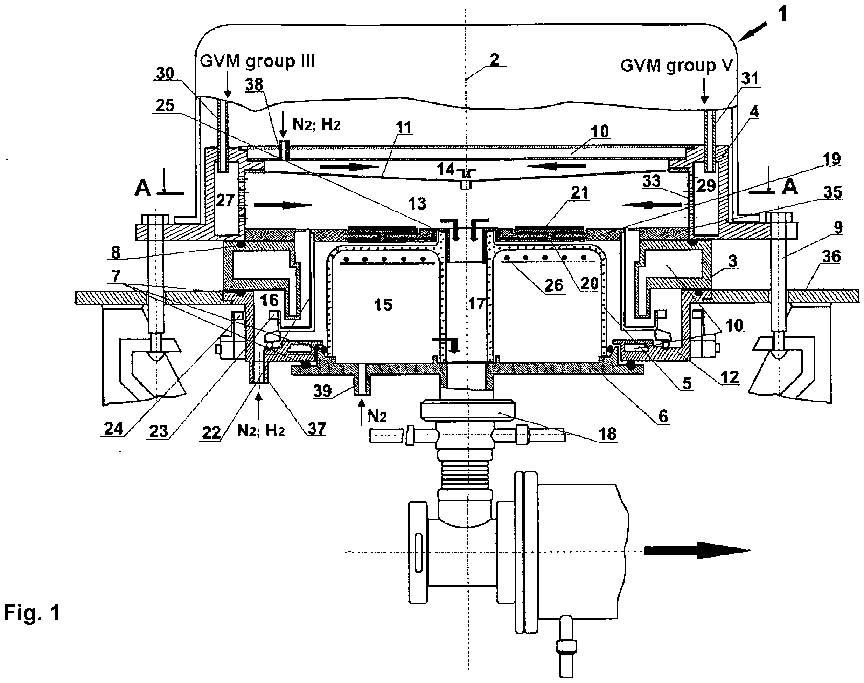

In another preferable embodiment of the method, the used screen has a shape of a cone having an angle between the vertical central axis and the surface of the screen, the angle ranging from 90° to 60° (see Fig. 1, position 11).

The reaction gas and carrier gas may be supplied into the reaction chamber via the peripheral part of the reactor and removed via the central part thereof; alternatively, the reaction gas and carrier gas may be supplied into the reaction chamber via the central part of the reactor and removed via the peripheral part thereof.

In still another preferable embodiment of the method, the substrates disposed on the substrate holder undergo rotation simultaneously with rotation of the substrate holder relative to the vertical central axis. This allows elimination of the component concentration decrease effective along the radius of the reaction chamber.

The claimed method may be used for producing epitaxial structures of III-V compounds and II-VI compounds.

### Brief Description of Drawings

Fig. 1 is a side cross-section of one of embodiments of the reactor for implementing the method of the invention.
Fig. 2 is a partial top view of the reactor of Fig. 1.
Fig. 3 is a schematic top view of the reactor, conventionally showing segments for supply of reaction gases containing compounds of elements of groups III and V.
Fig. 4 is a schematic cross-section of typical epitaxial structure produced using the method described in the above in the reactor shown in Figs. 1 to 3.

### Detailed Description of Invention

As it was described in the above, the claimed method is implemented in a reactor comprising a reaction chamber being symmetrical relative to the vertical central axis, in which chamber a GVM moves from the center to the periphery (or vice versa), wherein a rotary substrate holder, a means for supplying and removing gases, and a screen located above the substrate holder coaxially therewith are disposed inside the chamber. In order to improve quality of the produced structures, the supply of gases is divided into at least two main inputs and two additional (separation) inputs providing movement of the GVM over corresponding segments. The GVM containing group III element(s) compounds (i.e. TMG, TMA, etc.) moves via one main segment, the GVM containing a group V element compound (i.e. ammonia, arsine, etc.) moves via another main segment, and a carrier gas moves via separation segments.

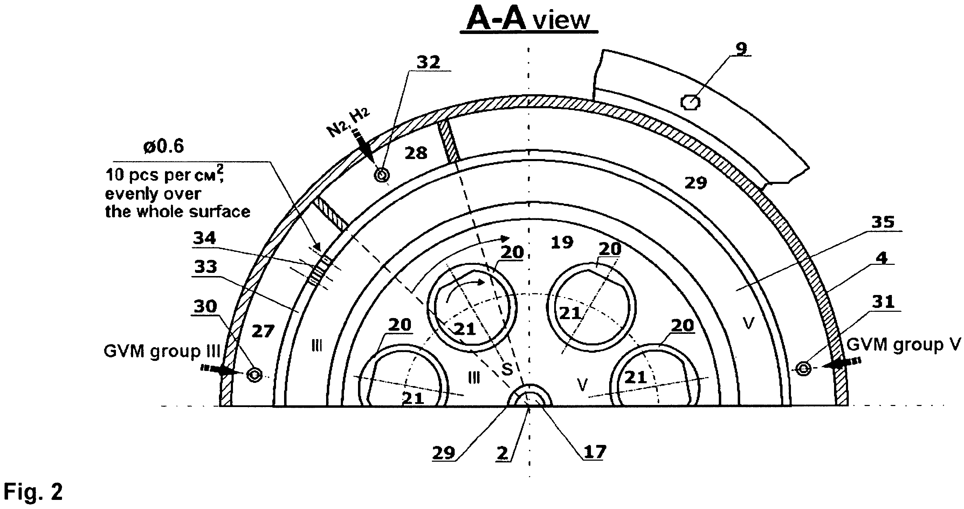

Implementation of the method described in the above is further explained by means of the example of operation of the reactor shown in Figs. 1 and 2.

The reactor (1) constitutes a cylinder framework being symmetrical relative to the vertical central axis (2). Proportions of the cylinder, in particular the diameter thereof, are defined according to substrate dimensions and other factors. The dimensions of substrates to be processed may be between 40 mm and 200 mm.

The reactor (1) comprises a base (3), an upper lid (4), a screen (11) attached to the lid (4) and being symmetrical relative to the vertical central axis (2), a quartz cap (5) disposed on a flange (6), and a substrate holder (19). The base (3), the upper lid (4), and a flange (12) are cooled by water supplied into cavities (10). The reactor is mounted on a heavy plate (36) in order to prevent vibration. The reactor is sealed by means of gaskets (7) and (8).

The upper lid (4) is equipped with a device for lifting thereof in order to load and unload the substrates after each process of epitaxial structure growth. Clamps (9) and the gasket (8) provide sealing the lid (4).

The reactor (1) comprises a region (13) into which the GVM containing reagents is supplied, and regions (14), (15), (16) which are blown off with nitrogen, hydrogen, or a mixture thereof via inputs (38), (39), (37) correspondingly. The distance between the surface formed by the substrate holder (19) and the surface of the screen (11) is 15 to 40 mm (typically 22 mm). Removal of all gases and reaction products in gaseous phase is performed via the central part (17) and further via a device (18) for outputting thereof.

The reactor is designed so as to provide pressure of 10⁻³ torr to 600 torr (1 atmosphere) in the region (13).

The substrate holder (19) disposed inside the reactor chamber is equipped with satellites (20) on which the substrates (21) are mounted (see Fig. 2). The satellites are configured to rotate relative to the vertical axes thereof. The substrate holder (19) is located on a cylinder (22) rotating relative to the vertical central axis (2) due to magnetic coupling between internal magnets (23) and external magnets (24). A driving pinion (25) is fixed on the cap (5), and each satellite (20) has a driven pinion which is located at the bottom side thereof and revolves around the driving pinion (25) as the substrate holder (19) rotates, thus providing additional rotation of the satellites relative to their own axes.

Heating the substrates is performed by a heat device (26) providing heating up and maintaining temperature of the substrates in the range of 400°C to 1300°C. The heat device comprises three fields symmetrical relative to the vertical central axis (2), thus enabling formation of a uniform temperature field on the satellites.

Inputting the GVM into the growth region of the reactor (region (13)) is performed in the following way. The upper lid (4) comprises two cavities (27), (29) for supplying the GVM and two cavities (28) for blowing off with the carrier gas. Components are supplied into the cavities (27), (29) via an input (30) for the GVM containing a group III component, via an input (31) for the GVM containing a group V component, and via two inputs (32) for the blow off gas.

The inner surface (33) of the upper lid (4) comprises openings (34) of 0.6 mm diameter, distributed evenly across the surface (33) with a density of about 10 openings per square centimeter, thus providing, jointly with a collar (35) and owing to the form of the region (13), laminar GVM flowing.

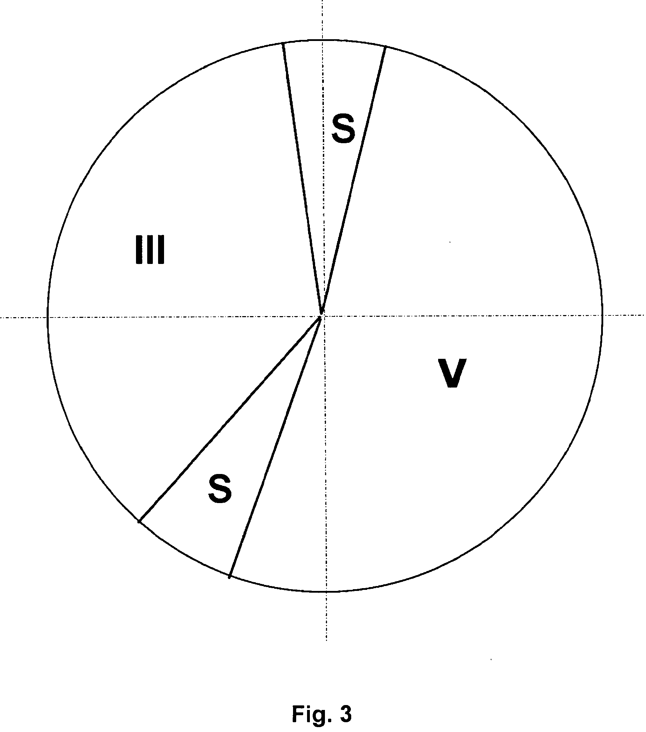

Separate supply of the GVM into the growth region is provided owing to symmetrical design of the reactor in which the GVM laminarly flows from the peripheral part of the reactor to the center thereof, thus forming the segment of the GVM containing the group III component and the group V component correspondingly (see Fig. 3), while the evenly rotating substrate holder (19) sequentially and evenly moves substrates (21) from one segment to another one. In order to separate the group III component from the group V component more effectively, additional inputs are disposed between the main inputs, and carrier gases (H₂, N₂ or a mixture thereof) are supplied via the additional inputs. The substrate holder rotation speed and content of the MOC in the GVM are determined to be such that a layer having thickness close to monoatomic one deposits on the substrate during the time of passing thereof though the group III segment (typically 10 rpm). The speed of the layer growth may be adjusted by changing the substrate holder rotation speed in the range of 6 rpm to 15 rpm. The doping component is supplied into the group III segment or the group VI segment of the cavity (27), (29) correspondingly, depending on desirable type of conductivity of the growing layer. The process of growing the layer in the reactor proceeds continuously; and all gas flows are steady during the growing time.

In order to avoid non-laminar flow of the GVM in the region (13), the screen (11) has a temperature of 0.6 to 0.9 relative to the temperature of the satellites (20) and this is assured by the composition of the nitrogen-hydrogen mixture, the volume thereof used for blowing off the region (14), and the distance between the upper surface of the lid (4) and the surface of the screen (11).

The nitrogen-hydrogen mixture is to be supplied into the cavities (27), (28), (29) typically at the rate of 30 liters per minute totally (the inner diameter of the upper lid (4), defined by the surface (33) is 360 mm).

The consumption rate of the nitrogen-hydrogen mixture supplied into each of the cavities (27), (28), (29) is proportional to the area of the surface (33) portion that assures the GVM flowing in each of segments III, V, S (see Fig. 3). In the reactor under consideration these areas have proportions 30/58/(6x2). Accordingly, the GVM flows for different regions are as follows: 9.0 liters per minute for the cavity (27), 17.4 liters per minute for the cavity (29), and 3.6 liters per minute for the cavities (28).

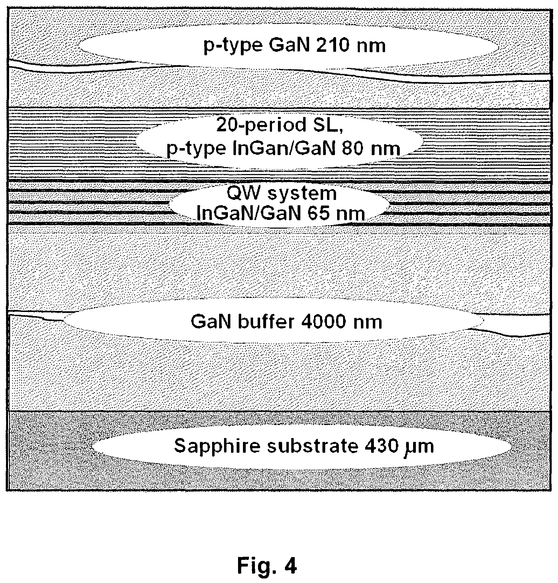

Fig. 4 shows a schematic cross-section of a typical epitaxial structure produced using the reactor described in the above. The epitaxial structure is intended for production of LEDs having green light emission.

The following have been used as initial components of the process:
(A) a reagent of group III (trimethylgallium (TMG), trimethylindium (TMI), trimethylaluminium (TMA));
(B) a reagent of group V (ammonia (NH₃));
(C) doping components (monosilane (SiH₄) having volume concentration of 10⁻³% in vessel and a magnesium metal-organic composition (bis(cyclopentadienyl)magnesium)).

Templates, namely sapphire substrates bearing a layer about 4000 nm thick of GaN doped with silicon at concentration of 3.0·10¹⁸ cm⁻³, are placed into the reactor. Then necessary blow-offs are performed. After that the substrates are heated up to 400°C and NH₃ is supplied into the segment V of the reactor at the rate of 0.35 mole per minute and heating is maintained up to the temperature of 1050°C.

Once the temperature of 1050°C has been reached, the ammonia supply rate is increased to 0.53 mole per minute; TMG at the rate of 3.0·10⁴ mole per minute and monosilane at the rate of 1.0·10⁻⁷ mole per minute are supplied into the segment III of the reactor. The GaN layer is grown during 3 minutes and 52 seconds, after that supply of TMG and monosilane is stopped and the temperature is decreased to 730°C.

Further a layer of InGaN is grown for the system of quantum wells (QW), by increasing the ammonia supply rate to 0.63 mole per minute in the segment V of the reactor, and TMG at the rate of 0.375·10⁻⁴ mole per minute and TMI at the rate of 2.0·10⁻⁶ mole per minute are supplied into the segment III of the reactor during 1 minute. After that TMG and TMI supply into the reactor is stopped, and the temperature is increased to 950°C. At this temperature a barrier GaN layer is grown during 1 minute and 30 seconds by supply of TMG at the rate of 2.0·10⁻⁶ mole per minute into the segment III of the reactor and supply of ammonia at the rate of 0.58 mole per minute into the segment V of the reactor. Once the growth of the barrier layer is finished, TMG supply into the reactor is stopped, and the temperature is again decreased to 730°C.

Further a second layer of InGaN is grown for the QW system and still further a second barrier layer of GaN is grown as indicated in the above. Thus, 5 layers of each of InGaN and GaN are grown for the QW system.

Once the growth of the last GaN barrier layer is finished, TMG supply is stopped, and the temperature is increased to 1050°C. Further a 20-period superlattice (SL) is grown, wherein the SL consists of interchanged GaN and AlGaN layers. In order to do that a doping component (bis(cyclopentadienyl)magnesium) is added at the rate of 3.2·10⁻⁷ mole per minute into the segment V, the rate of ammonia is maintained to be 0.58 mole per minute, and TMG at the rate of 1.2·10⁻⁴ mole per minute and TMA at the rate of 1.0·10⁻⁵ mole per minute are supplied into the segment III, TMA supply into the segment III is stopped in 48 seconds and is resumed again at the above-specified rate after 36 seconds. The cycles of 48 seconds of supplying TMA and 36 seconds of stopped TMA supply are repeated 20 times, thus growing the 20-period SL of p-type Al_{0.20}Ga_{0.80}N/GaN.

After the 20^{th} cycle TMA supply into the reactor is stopped, a doping component (bis(cyclopentadienyl)magnesium) is supplied at the rate of 3.2·10⁻⁷ mole per minute into the segment III, and a GaN layer is grown during 8 minutes (thus a layer 210 nm thick of GaN having p-type charge carrier concentration of 1.0·10¹⁸ cm⁻³ is obtained). After that supply of TMG and the doping component into the reactor is stopped and the heating is switched off while decreasing supply rate of ammonia to 0.36 mole per minute into the segment V. Once the temperature of 400°C is reached, supply of NH₃ is stopped. The reactor is then cooled down and blown off with nitrogen, and the produced structures are unloaded from the reactor.

The claimed method allows growing HES in industrial reactors with load of 6 to 60 substrates and provides high quality of the HES layers.

## Claims

1. A method of producing epitaxial layer of a binary semiconductor material on a monocrystalline substrate via metal-organic chemical vapour deposition (MOCVD), using the following means:
(A) a reactor having a reaction chamber being round relative to the vertical central axis;
(B) a substrate holder disposed horizontally in the reaction chamber and adapted to rotate relative to the vertical central axis;
(C) a round screen disposed in the reaction chamber at a distance of between 15 mm and 40 mm above the substrate holder, the screen having diameter bigger than the substrate holder diameter;
wherein
(a) a predetermined temperature of the substrate holder is maintained;
(b) the substrate holder is rotated uniformly relative to the vertical central axis;
(c) at least two reaction gases are supplied simulteneously and separately into different radial segments of the reaction chamber; wherein at least one of the gases contains a metal-organic compound (MOC) able to decompose in order to provide formation of a layer of atoms of an element of group III or group II, and at least another one of the gases contains hydride of an element of group V or group VI correspondingly, the hydride able to react with the atoms of the element of group III or group II in the layer, correspondingly;
(d) the reaction gases are supplied in such an order that the layer produced from the reaction gas containing MOC of the element of group III or group II is exposed to action of the reaction gas containing hydride of the element of group V or group VI, correspondingly;
(e) in order to avoid mixing the reaction gases to each other, a carrier gas is supplied into radial segments between the flows of the reaction gases;
(f) the reaction gases and the carrier gas are supplied into the reaction chamber continuously during the whole time of the layer growth;
(g) the reaction gases and the carrier gas are supplied in such a way that movement thereof in radial direction with speed being uniform relative to the same diameter is provided in every segment within the reaction chamber;
(h) the circular velocity of the substrate holder rotation, the concentration of MOC in the reaction gas, and the reaction gas consumption rate are provided in such a way that thickness of the layer deposited at one whole rotation cycle of the substrate holder is approximately 0.6 to 1.0 of monoatomic layer thickness;
(i) the reaction gases and the carrier gas are supplied substantially horizontally via groups of openings having diameter less than 1 mm and disposed with surface density of 5 to 20 openings per square centimeter in such a way that the gases flow in radial direction above the substrate holder laminarly in a displacement manner and thickness *d* of the growing layer is substantially equal to *k*×*a*×*n*, wherein
*k* is a positive real number characterizing the portion of the monoatomic layer thickness, deposited at one whole rotation cycle of the substrate holder;
*a* is a positive real number characterizing the crystal lattice parameter of the growing material;
*n* is a positive integer number characterizing the number of whole rotation cycles of the substrate holder.

2. The method of claim 1, wherein the temperature of the screen is maintained in the range of 0.6 to 0.9 in relation to the temperature of the substrate holder so as to avoid formation of recirculation in the reaction chamber.

3. The method of claim 1, wherein the screen is in the form of a cone having an angle between the vertical central axis and the surface of the screen, the angle ranging from 90° to 60°.

4. The method of claim 1, wherein the reaction gases and the carrier gas are supplied into the reaction chamber via the peripheral part of the reactor and removed via the central part thereof.

5. The method of claim 1, wherein the reaction gases and the carrier gas are supplied into the reaction chamber via the central part of the reactor and removed via the peripheral part thereof.

6. The method of claim 1, wherein the substrates disposed on the substrate holder undergo rotation simultaneously with rotation of the substrate holder relative to the vertical central axis.

7. The method of claim 1, wherein the reaction gas containing at least two compounds of elements belonging to group III or group II of the periodic table are supplied into one of the reactor segments and the reaction gas containing at least one hydride of an element belonging to group V or group VI of the periodic table is supplied into another segment of the reactor.

## Patentansprüche

1. Verfahren zum Herstellen einer epitaktischen Schicht eines binären Halbleitermaterials auf einem monokristallinen Substrat mittels metallorganischer chemischer Gasphasenabscheidung (MOCVD) unter Verwendung der folgenden Mittel:
(A) ein Reaktor mit einer Reaktionskammer, die relativ zu der vertikalen Mittelachse rund ist;
(B) ein Substrathalter, der horizontal in der Reaktionskammer angeordnet ist und angepasst ist, sich relativ zu der vertikalen Mittelachse zu drehen;
(C) ein runder Schirm, der in der Reaktionskammer in einem Abstand von zwischen 15 mm und 40 mm über dem Substrathalter angeordnet ist, wobei der Schirm einen Durchmesser hat, der größer ist als der Durchmesser des Substrathalters;
wobei
(a) eine vorbestimmte Temperatur des Substrathalters aufrechterhalten wird;
(b) der Substrathalter relativ zu der vertikalen Mittelachse gleichmäßig gedreht wird;
(c) mindestens zwei Reaktionsgase gleichzeitig und separat in unterschiedliche Radialsegmente der Reaktionskammer zugeführt werden; wobei mindestens eines der Gase eine metallorganische Komponente (MOC) enthält, die zum Zerlegen fähig ist, um eine Bildung einer Schicht von Atomen aus einem Element aus Gruppe III oder Gruppe II bereitzustellen, und mindestens ein anderes der Gase, das ein Hydrid aus einem Element aus jeweils Gruppe V oder Gruppe VI enthält, wobei das Hydrid fähig ist, mit den Atomen des Elements aus jeweils Gruppe III oder Gruppe II in der Schicht zu reagieren;
(d) die Reaktionsgase in solch einer Reihenfolge zugeführt werden, dass die Schicht, die aus dem Reaktionsgas, das MOC aus den Elementen aus Gruppe III oder Gruppe II enthält, der Wirkung des Reaktionsgases, das Hydrid aus den Elementen aus jeweils Gruppe V oder Gruppe VI enthält, ausgesetzt ist;
(e) ein Trägergas in Radialsegmente zwischen den Strömungen der Reaktionsgase zugeführt wird, um ein Mischen der Reaktionsgase untereinander zu vermeiden;
(f) die Reaktionsgase und das Trägergas in die Reaktionskammer während der gesamten Zeit des Schichtenwachstums kontinuierlich zugeführt werden;
(g) die Reaktionsgase und das Trägergas in solch einer Art zugeführt werden, dass eine Bewegung derselben in radialer Richtung mit einer Geschwindigkeit vorgesehen ist, die relativ zu dem gleichen Durchmesser in jedem Segment innerhalb der Reaktionskammer gleichbleibend ist;
(h) die Kreisgeschwindigkeit der Substrathalterdrehung, die Konzentration von MOC in dem Reaktionsgas, und die Reaktionsgas-Verbrauchsrate auf solch eine Art bereitgestellt werden, dass eine Dicke der Schicht, die bei einem vollständigen Umlaufzyklus des Substrathalters abgelagert wird, annähernd 0,6 bis 1,0 der monoatomaren Schichtdicke beträgt;
(i) die Reaktionsgase und das Trägergas im Wesentlichen horizontal zugeführt werden über Gruppen von Öffnungen mit einem Durchmesser von weniger als 1 mm und die mit einer Oberflächendichte von 5 bis 20 Öffnungen pro Quadratzentimeter derart angeordnet sind, dass die Gase in radialer Richtung laminar über dem Substrathalter in einer verdrängenden Weise strömen und die Dicke d der wachsenden Schicht im Wesentlichen gleich *k*×*a*×*n* ist, wobei
*k* eine positive reelle Zahl ist, die den Abschnitt der monoatomaren Schichtdicke kennzeichnet, die bei einem vollständigen Umlaufzyklus des Substrathalters abgelagert wird;
*a* eine positive reelle Zahl ist, die den Kristallgitterparameter des wachsenden Materials kennzeichnet;
*n* eine positive ganze Zahl ist, die die Anzahl vollständiger Umlaufzyklen der Substrathalters kennzeichnet.

2. Verfahren nach Anspruch 1, wobei die Temperatur des Schirms in dem Bereich von 0,6 bis 0,9 in Bezug auf die Temperatur des Substrathalter aufrechterhalten wird, um so eine Rezirkulationsbildung in der Reaktionskammer zu vermeiden.

3. Verfahren nach Anspruch 1, wobei der Schirm in der Form eines Konus vorliegt mit einem Winkel zwischen der vertikalen Mittelachse und der Oberfläche des Schirms, wobei der Winkel von 90° bis 60° reicht.

4. Verfahren nach Anspruch 1, wobei die Reaktionsgase und das Trägergas in die Reaktionskammer über den peripheren Teil des Reaktors zugeführt und über den Mittelteil desselben entfernt werden.

5. Verfahren nach Anspruch 1, wobei die Reaktionsgase und das Trägergas in die Reaktionskammer über den Mittelteil des Reaktors zugeführt und über den peripheren Teil desselben entfernt werden.

6. Verfahren nach Anspruch 1, wobei die Substrate, die auf dem Substrathalter angeordnet sind, gleichzeitig mit einer Drehung des Substrathalters relativ zu der vertikalen Mittelachse einer Drehung unterzogen werden.

7. Verfahren nach Anspruch 1, wobei das Reaktionsgas mindestens zwei Verbindungen der Elemente der Gruppe III oder der Gruppe II des Periodensystems enthält, die in eines der Reaktorsegmente zugeführt werden, und wobei das Reaktionsgas, das mindestens ein Hydrid aus einem Element, das zur Gruppe V oder Gruppe VI des Periodensystems gehört, in ein anderes Segment des Reaktors zugeführt wird.

## Revendications

1. Procédé de production de couche épitaxiale d'une matière semiconductrice binaire sur un substrat monocristallin via un dépôt chimique en phase vapeur organométallique (MOCVD), utilisant les moyens suivants :
(A) un réacteur ayant une chambre de réaction étant circulaire par rapport à l'axe central vertical ;
(B) un porte-substrat disposé horizontalement dans la chambre de réaction et conçu pour tourner par rapport à l'axe central vertical ;
(C) un écran circulaire disposé dans la chambre de réaction à une distance entre 15 mm et 40 mm au-dessus du porte-substrat, l'écran ayant un diamètre plus grand que le diamètre de porte-substrat ;
dans lequel
(a) une température prédéterminée du porte-substrat est maintenue ;
(b) le porte-substrat est tourné uniformément par rapport à l'axe central vertical ;
(c) au moins deux gaz de réaction sont fournis simultanément et séparément dans des segments radiaux différents de la chambre de réaction ; dans lesquels au moins un des gaz contient un composé organométallique (MOC) susceptible de se décomposer afin de permettre la formation d'une couche d'atomes d'un élément du groupe III ou du groupe II, et au moins un autre des gaz contient de l'hydrure d'un élément du groupe V ou du groupe VI de manière correspondante, l'hydrure étant susceptible de réagir avec les atomes de l'élément du groupe III ou du groupe II dans la couche, de manière correspondante ;
(d) les gaz de réaction sont fournis dans un ordre tel que la couche produite à partir du gaz de réaction contenant le MOC de l'élément du groupe III ou du groupe II est exposée à l'action du gaz de réaction contenant l'hydrure de l'élément du groupe V ou du groupe VI, de manière correspondante ;
(e) afin d'éviter de mélanger les gaz de réaction les uns aux autres, un gaz porteur est fourni dans des segments radiaux entre les flux des gaz de réaction ;
(f) les gaz de réaction et le gaz porteur sont fournis dans la chambre de réaction de façon continue pendant le temps entier de la croissance de couche ;
(g) les gaz de réaction et le gaz porteur sont fournis d'une façon telle qu'un mouvement de ces derniers dans la direction radiale avec une vitesse uniforme par rapport au même diamètre est permis dans chaque segment à l'intérieur de la chambre de réaction ;
(h) la vitesse circulaire de la rotation de porte-substrat, la concentration de MOC dans le gaz de réaction, et le débit de consommation de gaz de réaction sont permis d'une façon telle que l'épaisseur de la couche déposée au niveau d'un cycle de rotation entier du porte-substrat est d'environ 0,6 à 1,0 de l'épaisseur de couche monoatomique ;
(i) les gaz de réaction et le gaz porteur sont fournis sensiblement horizontalement via des groupes d'ouvertures ayant un diamètre inférieur à 1 mm et disposés avec une densité surfacique de 5 à 20 ouvertures par centimètre carré d'une façon telle que les gaz s'écoulent dans la direction radiale au-dessus du porte-substrat de façon laminaire par déplacement et une épaisseur d de la couche en croissance est sensiblement égale à *k×a×n,* dans laquelle
*k* est un nombre réel positif caractérisant la portion de l'épaisseur de couche monoatomique, déposée au niveau d'un cycle de rotation entier du porte-substrat ;
*a* est un nombre réel positif caractérisant le paramètre de réseau cristallin du cristal de la matière en croissance ;
*n* est un nombre entier positif caractérisant le nombre de cycles de rotation entière du porte-substrat.

2. Procédé selon la revendication 1, dans lequel la température de l'écran est maintenue dans la plage de 0,6 à 0,9 par rapport à la température du porte-substrat de façon à éviter la formation de recyclage dans la chambre de réaction.

3. Procédé selon la revendication 1, dans lequel l'écran est sous la forme d'un cône ayant un certain angle entre l'axe central vertical et la surface de l'écran, l'angle allant de 90° à 60°.

4. Procédé selon la revendication 1, dans lequel les gaz de réaction et le gaz porteur sont fournis dans la chambre de réaction via la partie périphérique du réacteur et enlevés via la partie centrale de ce dernier.

5. Procédé selon la revendication 1, dans lequel les gaz de réaction et le gaz porteur sont fournis dans la chambre de réaction via la partie centrale du réacteur et enlevés via la partie périphérique de ce dernier.

6. Procédé selon la revendication 1, dans lequel les substrats disposés sur le porte-substrat subissent une rotation simultanément avec la rotation du porte-substrat par rapport à l'axe central vertical.

7. Procédé selon la revendication 1, dans lequel le gaz de réaction contenant au moins deux composés d'éléments appartenant au groupe III ou au groupe II du tableau périodique est fourni dans un des segments de réacteur et le gaz de réaction contenant au moins un hydrure d'un élément appartenant au groupe V ou au groupe VI du tableau périodique est fourni dans un autre segment du réacteur.
